# FASCICULE DE BREVET EUROPEEN

(11) **EP 4 342 006 B1**
(45) Date de publication et mention de la délivrance du brevet: **17.09.2025**
(21) Numéro de dépôt: 22730105.8
(22) Date de dépôt: 17.05.2022
(51) Int. Cl.: H10N 50/01, H10N 50/10, H10B 61/00

(54) **PROCÉDÉ DE FABRICATION D'UN POINT MÉMOIRE SOT-MRAM ASYMÉTRIQUE ET POINT MÉMOIRE OBTENU PAR LA MISE EN OEUVRE DE CE PROCÉDÉ PROCÉDÉ DE FABRICATION D'UN POINT MÉMOIRE SOT-MRAM ASYMÉTRIQUE, LEDIT POINT MÉMOIRE COMPORTANT UNE PISTE CONDUCTRICE ET UN PLOT, DISPOSÉ SUR LA PISTE CONDUCTRICE ET COMPORTANT AU MOINS UNE PREMIÈRE**
VERFAHREN ZUR HERSTELLUNG EINER ASYMMETRISCHEN SOT-MRAM-SPEICHERZELLENEINHEIT UND DURCH IMPLEMENTIERUNG DIESES VERFAHRENS ERHALTENE SPEICHERZELLENEINHEIT
METHOD FOR FABRICATING AN ASYMMETRIC SOT-MRAM MEMORY CELL UNIT, AND MEMORY CELL UNIT OBTAINED BY IMPLEMENTING THIS METHOD

(30) Priorité: 18.05.2021 FR 2105175
(43) Date de publication de la demande: 27.03.2024
(73) Titulaire: Centre National de la Recherche Scientifique, 75016 Paris (FR); Université Paris-Saclay, 91190 Gif-sur-Yvette (FR); Commissariat à l'Energie Atomique et aux Energies Alternatives, 75015 Paris (FR)
(72) Inventeur: GAUDIN, Gilles, 38700 Corenc (FR); MIRON, Ioan Mihai, 38000 Grenoble (FR); BOULLE, Olivier, 38000 Grenoble (FR); RAVELOSONA, Dafine, 91190 Villiers Le Bacle (FR)
(74) Mandataire: IPAZ
(86) Numéro de dépôt international: PCT/EP2022/063257
(87) Numéro de publication internationale: WO 2022/243279

(56) Documents cités:
- FR-A1- 3 002 690
- FR-A1- 3 031 622
- US-A1- 2013 285 177
- US-A1- 2014 038 311
- US-A1- 2016 293 835

## Description

L'invention a pour domaine général celui des mémoires non-volatiles du type SOT-MRAM asymétriques. Plus particulièrement, l'invention est relative aux procédés de fabrication d'un point mémoire SOT-MRAM.

Un point mémoire MRAM (selon l'acronyme anglais « Magnetic Random Access Memory », ou « mémoire à accès aléatoire magnétique » en français) comporte un plot constitué de l'empilement d'une pluralité de régions d'épaisseur faible. Cette pluralité de régions comporte au moins une première région magnétique présentant une aimantation libre, une seconde région magnétique présentant une aimantation figée et une région formant une barrière tunnel, à l'interface entre les première et seconde régions magnétiques.

La direction de l'aimantation dans les première et seconde régions magnétiques peut être soit parallèle au plan des régions, soit perpendiculaire au plan des régions. Dans le présent document, le cas d'une direction d'aimantation perpendiculaire sera plus particulièrement décrit, mais cet enseignement s'étend directement au cas d'une direction d'aimantation parallèle.

Le sens de l'aimantation dans la première région magnétique permet de stocker une information binaire.

Pour un point mémoire STT-MRAM (« Spin Transfer Torque MRAM », ou « MRAM à couple de transfert de spin »), l'écriture d'une information binaire s'effectue par l'injection d'un courant d'écriture à travers le plot (c'est-à-dire perpendiculairement au plan des régions), puis la lecture de l'information stockée s'effectue par l'injection d'un courant de lecture également à travers le plot.

Cette technologie présente des désavantages, notamment de présenter une vitesse d'écriture réduite liée à un vieillissement rapide de la mémoire pour des densités de courant d'écriture élevées, et de conduire à des erreurs entre étapes de lecture et d'écriture au sein d'un réseau de points mémoire STT-MRAM.

Ont alors été proposés les points mémoire SOT-MRAM (« Spin Orbit Torque MRAM », ou « MRAM à couple de spin-orbite »), pour lesquels le plot est disposé au centre d'une piste conductrice dont les deux extrémités sont munies d'électrodes.

L'écriture s'effectue alors par l'injection d'un courant d'écriture entre les deux électrodes, à travers la piste conductrice, c'est-à-dire parallèlement au plan des régions du plot, tandis que la lecture s'effectue, comme pour un point mémoire STT-MRAM, par l'injection d'un courant de lecture perpendiculairement au plan des régions, à travers le plot.

Cependant, pour fonctionner efficacement, un point mémoire SOT-MRAM doit être placé dans un champ magnétique externe de polarisation ayant une composante colinéaire à la direction d'injection du courant d'écriture. Or, le moyen de génération d'un tel champ magnétique est la cause de difficultés importantes d'intégration des mémoires SOT-MRAM.

C'est pourquoi, plus récemment, ont été proposés des points mémoire SOT-MRAM asymétriques. Par exemple, le document FR 3 031 622 A1, décrit différents modes de réalisation d'un point mémoire SOT-MRAM asymétrique. Les documents US2014/038311 A1, US2013/285177 A1, FR 3 002 690 A1 et US2016/293835 A1 montrent des procédés différents de traitement d'une structure magnétique dans une mémoire MRAM.

Dans le document FR 3 031 622 A1 précité, l'asymétrie résulte de la conformation du plot de manière à ce qu'il ne soit plus symétrique par rapport à un plan de référence, qui est à la fois perpendiculaire au plan des régions du plot et parallèle à la direction d'injection du courant d'écriture dans la piste conductrice.

Cette asymétrie géométrique permet de créer une brisure de la symétrie miroir par rapport au plan de référence, ayant sensiblement les mêmes effets que l'application d'un champ magnétique externe de polarisation. Avec les points mémoire SOT-MRAM asymétriques, il n'est alors plus nécessaire d'utiliser un champ magnétique externe.

Avantageusement, le plot présente en outre des pointes permettant d'amorcer le basculement de l'aimantation dans la première région magnétique en fonction du sens d'injection du courant dans la piste conductrice. Ces pointes présentent des dimensions très petites, ce qui rend d'autant plus difficile la production industrielle des plots.

Les points mémoire SOT-MRAM asymétriques ayant démontré leur intérêt, se pose alors le problème de la fabrication à une échelle industrielle de ces dispositifs mémoire non-volatile.

En effet, en laboratoire, pour la fabrication d'échantillons à des tailles compatibles avec une utilisation industrielle, typiquement en dessous de 100 nm, les procédés mis en oeuvre utilisent classiquement la lithographie électronique.

S'ils permettent de définir des plots mémoire SOT-MRAM asymétriques avec la précision requise, ces procédés sont caractérisés par des vitesses de fabrication réduites. Ceci est notamment dû à la nécessité de déplacer le faisceau électronique pour effectuer l'insolation de la résine qui sert à définir la forme de chaque point mémoire. De tels procédés ne sont donc pas compatibles avec une production industrielle où l'on cherche par exemple à structurer sur une tranche de semi-conducteur (ou « wafer ») de 300 mm de rayon, plusieurs milliards de points mémoire le plus rapidement possible.

L'invention a par conséquent pour objet de résoudre ce problème, en proposant notamment un procédé de fabrication de points mémoire SOT-MRAM avec les débits requis par l'industrie.

Pour cela l'invention a pour objet un procédé de fabrication d'un point mémoire SOT-MRAM asymétrique, le point mémoire comportant une piste conductrice et un plot, disposé sur la piste conductrice et comportant au moins une première région magnétique à aimantation libre, le procédé étant caractérisé en ce qu'il comporte les étapes consistant à : réaliser un empilement d'une pluralité de couches étendues, comportant au moins une première couche magnétique étendue ; déposer un masque sur une surface supérieure de l'empilement ; et, délimiter la première région magnétique dans la première couche magnétique étendue par une irradiation ionique de la surface supérieure de l'empilement portant le masque, les paramètres de l'irradiation ionique étant adaptés pour modifier des propriétés magnétiques du matériau constitutif de la première couche magnétiques.

Suivant des modes particuliers de réalisation, le procédé comporte une ou plusieurs des caractéristiques suivantes, prises isolément ou suivant toutes les combinaisons techniquement possibles :
- l'irradiation ionique permet de modifier les propriétés magnétiques d'une zone de la première couche magnétique exposée lors de l'irradiation ionique, tout en conservant les propriétés magnétiques d'une zone de la première couche magnétique non-exposée lors de l'irradiation ionique à cause de la présence du masque.
- l'étape de délimitation par irradiation ionique comporte, au cours d'une durée de l'irradiation, un déplacement relatif d'une source d'ions par rapport à la surface supérieure de l'empilement portant le masque de manière à modifier une direction de l'irradiation, les paramètres de l'irradiation étant adaptés pour supprimer les propriétés magnétiques d'une zone exposée durant toute la durée de l'irradiation, mais pour ne pas supprimer les propriétés magnétiques d'une zone exposée uniquement pendant une fraction de la durée de l'irradiation.
- l'étape de délimitation par irradiation ionique comporte une première irradiation selon une première direction de l'irradiation, suivie d'une seconde irradiation selon une seconde direction de l'irradiation, les paramètres de la première irradiation et de la seconde irradiation étant choisis pour supprimer les propriétés magnétiques d'une zone exposée à la fois lors de la première irradiation et lors de la seconde irradiation, mais ne pas supprimer les propriétés magnétiques d'une zone exposée uniquement lors de la première irradiation ou uniquement lors de la seconde irradiation.
- Le procédé comporte, entre les première et seconde irradiations ioniques, une étape de modification du masque.
- l'irradiation ionique met en œuvre des ions légers, de préférence He+, de faible énergie, de préférence entre 10 et 100 keV, de préférence encore égale à 30 keV, et avec une intensité entre 10¹⁴ et 10¹⁷ ions/cm², de préférence égale à 10¹⁶ ions/cm².
- le procédé comporte, après l'étape de dépôt d'un masque et avant l'étape de délimitation par irradiation ionique, une étape de gravure consistant à graver les couches supérieures de l'empilement autour du masque déposé de manière à ce que le flux d'ions utilisé lors de l'irradiation ionique puisse atteindre la première couche magnétique.
- réaliser un empilement d'une pluralité de couches étendues consiste à superposer, sur un substrat semi-conducteur, une couche conductrice, une première couche magnétique, une couche intermédiaire, une seconde couche magnétique et une couche d'électrode.
- le procédé comportant, après l'étape de délimitation par irradiation ionique, une étape de finition du point mémoire consistant à supprimer le masque, à graver l'empilement pour exposer une piste conductrice de part et d'autre du plot, et réaliser des électrodes à chacune des extrémités de la couche conductrice, ainsi que sur le plot.

L'invention a également pour objet un point mémoire SOT-MRAM asymétrique obtenu par la mise en œuvre du procédé précédent.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :
[Fig 1] la figure 1 est une représentation théorique d'un point mémoire du type SOT-MRAM asymétrique et à aimantation perpendiculaire ;
[Fig 2] la figure 2 est une représentation, sous forme de blocs, d'un mode de réalisation du procédé de fabrication selon l'invention, permettant d'obtenir un point mémoire du type de celui représenté à la figure 1 ;

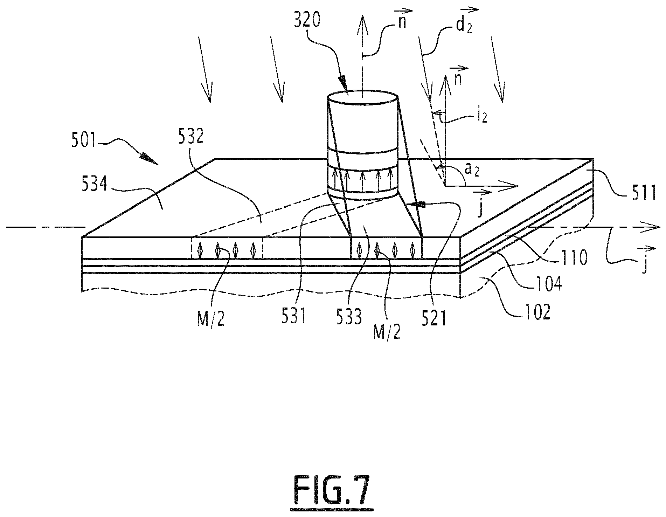

[Fig 3][Fig 4][Fig 5][Fig 6][Fig 7][Fig 8] les figures 3 à 8 représentent les composants obtenus à l'issue de chacune des étapes du procédé de la figure 2, la figure 9 représentant en particulier le plot mémoire obtenu par la mise en œuvre du procédé de la figure 2 ; et,
[Fig 9] la figure 9 illustre une mise en œuvre industrielle du procédé de la figure 2 pour fabriquer simultanément un grand nombre de points mémoire sur une tranche de semi-conducteur.

### 1. Dispositif mémoire que l'on souhaite fabriquer

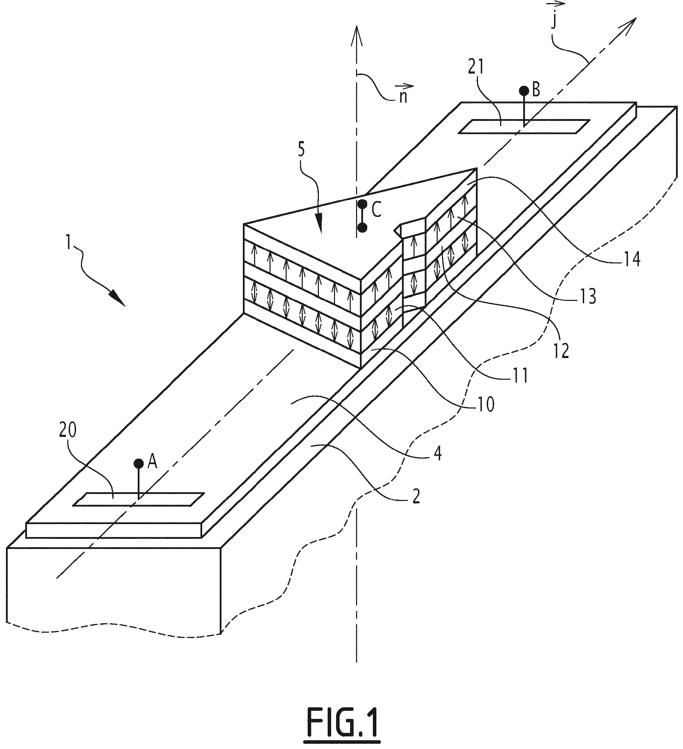

Un exemple de point mémoire que l'on cherche à réaliser est représenté sur la figure 1. Il s'agit d'un point mémoire du type SOT-MRAM asymétrique et à aimantation perpendiculaire.

Ce point mémoire 1 comprend, au-dessus d'une piste conductrice 4, un plot 5.

La piste conductrice 4 est de préférence formée sur un substrat 2.

Le substrat 2 est par exemple constitué d'une plaquette de silicium recouverte d'un oxyde de silicium.

La piste conductrice 4 est réalisée en un matériau conducteur du courant électrique, par exemple un métal, comme du cuivre Cu. Les matériaux utilisables pour la région 10, indiqués ci-dessous, peuvent également être utilisés pour la piste 4. Avantageusement, le même matériau est utilisé à la fois pour la piste 4 et la couche 10. En variante, la couche 10 n'est qu'une surépaisseur de la piste 4.

La piste conductrice 4 est rectiligne selon une direction j.

Au voisinage de ses extrémités, la piste conductrice 4 porte des électrodes, 20 et 21, constituant respectivement des bornes A et B.

Le plot 5 est disposé sensiblement au milieu de la piste conductrice 4.

Le plot 5 comprend une superposition de régions de faible épaisseur. Les régions sont empilées selon une direction perpendiculaire n, qui est orthogonale au plan de la piste conductrice 4.

Une région peut être formée d'un unique matériau ou d'un empilement de plusieurs strates de matériaux différents.

Le plot 5 comprend ainsi successivement, à partir de la piste conductrice 4 et selon la direction perpendiculaire n, une région conductrice de contact 10, une première région magnétique 11, une région intermédiaire 12, une seconde région magnétique 13 et une région d'électrode 14.

La région conductrice de contact 10 est réalisée en un matériau conducteur du courant électrique. Il peut par exemple s'agir d'un métal non magnétique, tel que Pt, W, Ir, Ru, Pd, Cu, Au, Bi, Hf ou d'un alliage de certains de ces métaux ou encore d'un empilement de plusieurs strates de certains de ces métaux ou alliages de ces métaux. Il peut aussi s'agir d'un matériau magnétique comme typiquement un matériau antiferromagnétique tel que PtMn, IrMn, FeMn, ...

La région conductrice de contact 10 présente une épaisseur comprise entre 0,5 nm et 200 nm, de préférence entre 0,5 nm et 100 nm, de préférence encore entre 0,5 nm et 3 nm.

La région conductrice de contact 10 peut être omise, à condition que la piste conductrice 4 soit en un matériau convenant à la croissance du matériau constitutif de la première région magnétique 11 et soit capable de générer un mécanisme de couple de spin-orbite - SOT (« spin-orbit torque » en anglais). La piste 4 est alors typiquement composée des matériaux listés ci-dessus pour la région conductrice de contact 10.

Les première et seconde régions magnétiques 11 et 13 sont réalisées en un matériau magnétique, ou un composé de matériaux magnétiques, ou de plusieurs strates de matériaux magnétiques et non-magnétiques. Il peut par exemple s'agir d'un alliage présentant une anisotropie magnétique perpendiculaire propre, tel que FePt, FePd, CoPt, ou bien encore d'un alliage de terre rare / métal de transition, tel que GdCo, TbFeCo. Il peut également d'agir d'un métal ou d'un alliage présentant une anisotropie magnétique perpendiculaire induite par les interfaces avec les régions voisines, notamment Co, Fe, CoFe, CoFeB, FeB, Ni, Py, CoNi.

La première région magnétique 11 présente une épaisseur comprise entre 0,7 et 3 nm, et plus précisément entre 0,8 et 1,4 nm.

La seconde région magnétique 13 présente une épaisseur généralement supérieure à celle de la première région 11. Elle est en effet souvent réalisée par la superposition de plusieurs strates.

Le région intermédiaire 12 est réalisée en un matériau non magnétique. Le matériau de la région 12 peut être conducteur, mais il est de préférence isolant. Il peut par exemple s'agir d'un oxyde diélectrique tel que MgO, SiO, AlO, TiO, TaO, HfO, ou d'un nitrure diélectrique, tel que SiN, BN.

Il est à noter que les formules chimiques des matériaux cités dans le présent document sont génériques au sens où elles ne précisent pas la stœchiométrie entre leurs composants, d'autant que cette stœchiométrie peut ne pas être atteinte dans le cristal formant le matériau considéré.

La région intermédiaire 12 présente par exemple une épaisseur comprise entre 0,5 nm et 200 nm, de préférence entre 0,5 nm et 100 nm, de préférence encore entre 0,5 nm et 3 nm.

En tout cas, la région intermédiaire 12, si elle est constituée d'un matériau isolant, est suffisamment fine pour pouvoir être traversée par des électrons par effet tunnel.

La région d'électrode 14 est réalisée en un matériau conducteur du courant électrique. La région 14 constitue une borne électrique C.

Pour le cas d'un point mémoire à aimantation perpendiculaire aux plans des régions du plot, il existe de préférence une différence structurelle entre les régions non magnétiques 10 et 12 de façon à créer un système asymétrique dans la direction perpendiculaire n. Cette différence peut résulter notamment d'une différence de matériau, d'épaisseur, ou de mode de croissance des matériaux de ces deux régions.

Toujours pour le cas d'un point mémoire à aimantation perpendiculaire, les matériaux magnétiques des première et seconde régions magnétiques 11 et 13 sont formés dans des conditions telles qu'ils présentent une aimantation dirigée selon la direction perpendiculaire **n.**

Le matériau magnétique de la seconde région magnétique 13 est formé dans des conditions telles qu'il conserve un sens de l'aimantation permanent (aimantation piégée). Par exemple, l'aimantation de la seconde région magnétique 13 est dans le même sens que la direction perpendiculaire **n.**

En revanche, le matériau magnétique de la première région magnétique 11 est formé dans des conditions telles que le sens de son aimantation peut être modifié (aimantation libre). L'aimantation de la première région magnétique 11 est ainsi soit dans le même sens que la direction perpendiculaire **n** (orientation « vers le haut » ou « up »), soit dans un sens opposé à la direction perpendiculaire **n** (orientation « vers le bas » ou « down »).

Un générateur de courant, non représenté sur la figure 1, permet la circulation d'un courant d'écriture entre les bornes A et B, à travers la piste conductrice 4. Le courant d'écriture circule sensiblement selon la direction **j**, dans un sens ou dans l'autre, dans le plan de la piste conductrice 4.

La « programmation » du point mémoire 1, c'est-à-dire le basculement de l'orientation de l'aimantation de la première région magnétique 11 dans un sens ou dans l'autre, est effectuée en faisant circuler un courant d'écriture selon la direction **j**, c'est-à-dire parallèlement au plan des régions constitutives du plot 5.

Selon le sens de circulation du courant d'écriture dans la piste conductrice 4 (soit dans le sens de la direction **j** entre les bornes A et B, soit dans le sens opposé à la direction **j** entre les bornes B et A) la première région magnétique 11 est programmée par sélection « vers le haut » ou « vers le bas » du sens de son aimantation.

Pour la lecture de l'état du point mémoire 1, une tension de lecture est appliquée (par un circuit de lecture, non représenté sur la figure 1) entre la borne C et l'une ou l'autre des bornes A et B. La mesure de la résistance du plot 5 est indicative de l'orientation relative de l'aimantation entre les première et seconde régions magnétiques 11 et 13.

Pour que ce comportement soit effectif même sans champ magnétique externe de polarisation, une asymétrie géométrique est introduite par le plot 5 par rapport à un plan de référence, qui est défini par les directions **j** et **n.**

Ainsi, dans le mode de réalisation illustré sur la figure 1, le plot 5 est conformé pour présenter, en vue de dessus, une forme en « V ». Il est positionné sur la piste conductrice 4 de manière à ce que le plan de référence ne coïncide pas avec un plan de symétrie du plot 5 (tel que, par exemple, un plan selon une bissectrice de la portion de pointe du « V » que forme le plot 5, d'où sont issues les deux branches latérales du « V » que forme le plot 5).

### 2. Généralités sur le procédé de fabrication selon l'invention

De manière générale, le procédé de fabrication selon l'invention met en oeuvre une technique d'irradiation ionique.

L'irradiation ionique est une technique connue et utilisée dans l'état de la technique soit pour graver un matériau, soit pour modifier la structure d'un matériau par implantation d'atomes.

Cependant, il a récemment été identifié que, dans certaines conditions (nature de l'ion utilisé, intensité du faisceau d'ions, temps d'exposition, etc.), les propriétés d'un matériau magnétique peuvent être altérées par irradiation ionique. En irradiant un matériau magnétique avec un flux d'ions, il est notamment possible de diminuer l'amplitude de l'aimantation de ce matériau magnétique, jusqu'à éventuellement l'éliminer complètement.

Le procédé selon l'invention se sert de cette propriété pour délimiter, dans une couche magnétique étendue, réalisée en un matériau magnétique, une région magnétique dont la forme correspond à celle de la première région magnétique du plot à fabriquer.

Pour cela, un pilier de masquage est disposé au-dessus de la couche magnétique étendue de manière à ce que, alors que l'irradiation ionique s'effectue avec un angle d'incidence non nulle, l'ombre projetée par le pilier de masquage sur la couche magnétique étendue empêche la modification des propriétés magnétiques à l'intérieur de la zone ombrée. En revanche, à l'extérieur de la zone ombrée, les propriétés magnétiques du matériau magnétique sont altérées, voire éliminées complètement.

Avantageusement, en effectuant l'étape d'irradiation pour différentes directions d'incidence (c'est-à-dire différents plans d'incidence et/ou différents angles d'incidence), il est possible de déplacer l'ombre projetée par le pilier de masquage pour dessiner précisément, dans la couche magnétique étendue, le contour de la première région magnétique du plot à réaliser.

### 3. Description détaillée d'un mode de réalisation du procédé selon l'invention pour la fabrication du point mémoire de la figure 1

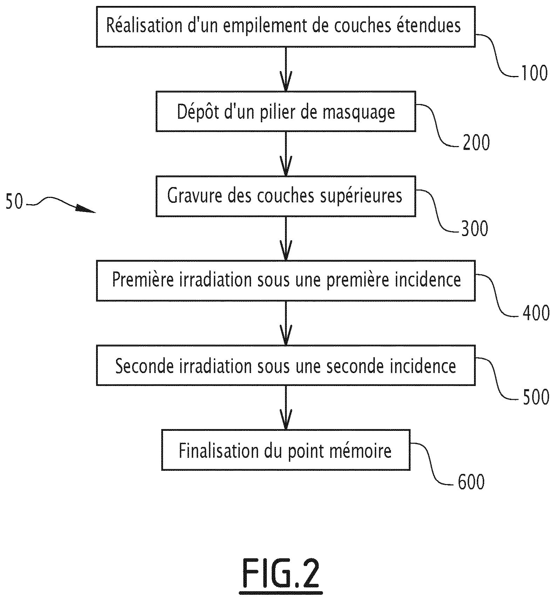

Plus précisément, en se reportant à la figure 2, le procédé de fabrication 50 comporte les étapes suivantes.

Dans une étape 100, un empilement est réalisé par la superposition d'une pluralité de couches étendues. La nature de ces couches étendues et leur ordre de superposition correspondent au point mémoire à fabriquer, en l'occurrence, dans le présent mode de réalisation, le point mémoire 1 de la figure 1.

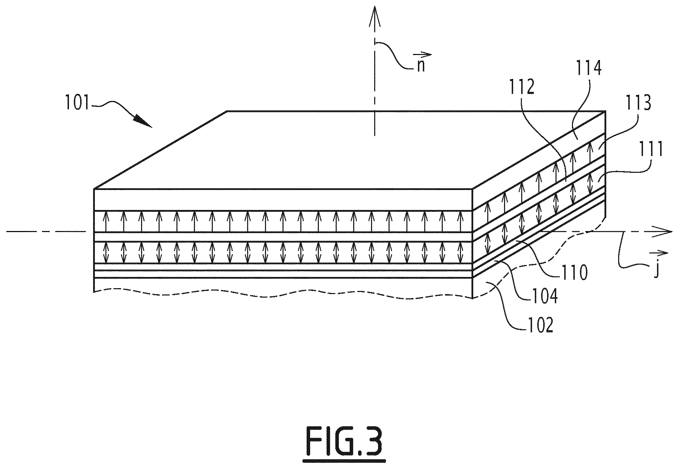

Comme représenté sur la figure 3, à l'issue de l'étape 100, le composant 101 obtenu comporte un substrat 102, une piste conductrice 104, une couche conductrice de contact 110, une première couche magnétique 111, une couche intermédiaire 112, une seconde couche magnétique 113 et une couche d'électrode 114.

Dans une étape 200, un pilier de masquage primaire est déposé sur l'empilement de couches étendues.

Il est par exemple réalisé en un matériau métallique tel que Ta, W, Ti, Pt, ou, en une résine, que l'on peut structurer par lumière UV (UV pour ultraviolet) ou faisceau électronique. Cette dernière possibilité est préférable pour une application industrielle.

Il présente une forme facilement réalisable avec les techniques de structuration connues, par exemple un cylindre à base circulaire. Le pilier de masquage primaire présente une hauteur H0 et un diamètre D0.

La réalisation du pilier de masquage primaire s'effectue par exemple en déposant une couche d'une photorésine. Le pilier est alors conformé dans cette couche épaisse par lithographie UV, suivie éventuellement d'une gravure ionique pour affiner la forme latérale du pilier. Le matériau étant consommé pendant l'étape de conformation, l'épaisseur de la couche initiale est choisie de manière à obtenir, à l'issue de la conformation, la hauteur H0 requise pour le pilier de masquage primaire.

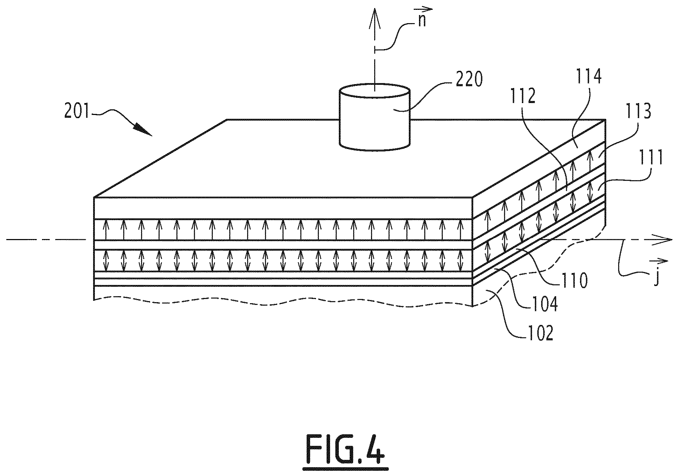

Comme représenté sur la figure 4, le composant 201 obtenu à l'issue de l'étape 200 présente un pilier de masquage primaire 220 au-dessus de l'empilement des couches étendues. Il est situé à l'aplomb de ce qui doit être la portion de pointe de la forme en « V » du plot 5 à fabriquer.

Avantageusement, dans une étape 300, l'empilement portant le pilier de masquage primaire est gravé, par la mise en oeuvre d'une technique conventionnelle, de manière à éliminer les couches étendues supérieures de l'empilement, autour du pilier de masquage primaire, jusqu'à par exemple exposer la surface supérieure de la première couche magnétique 111.

On notera que cette étape de gravure peut être réalisée en continuité de l'étape de conformation du plot de masquage primaire.

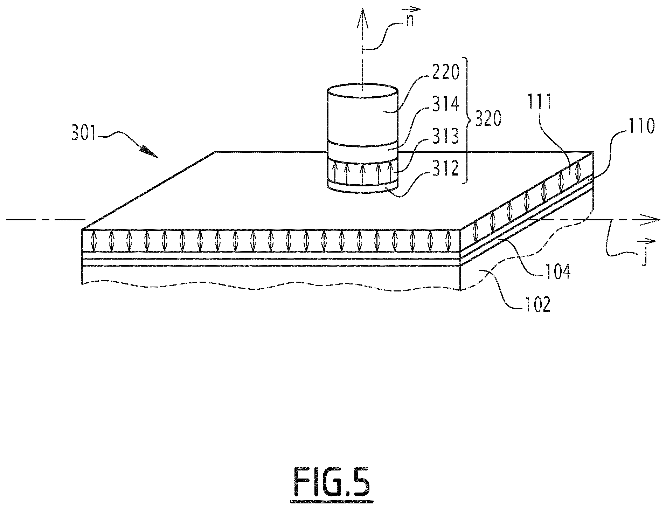

Est représenté sur la figure 5, le composant 301 obtenu à l'issue de l'étape 300. Si les couches inférieures de l'empilement ne sont pas modifiées par la gravure, les couches supérieures de celui-ci se limitent maintenant aux régions correspondantes du plot 5 à réaliser. Le composant 301 présente ainsi une région intermédiaire 312, une seconde région magnétique 313 et une région d'électrode 314. Ces régions supérieures et le pilier de masquage primaire 220 qui les surmonte forment ensemble un pilier de masquage 320.

Le pilier de masquage présente typiquement une hauteur H entre 10 et 150 nm, de préférence 50 nm, et un diamètre D entre 5 et 100 nm, de préférence entre 10 et 30 nm.

La hauteur H0 et le diamètre D0 du pilier de masquage primaire sont donc choisis en fonction des hauteurs H et D recherchées et des épaisseurs des couches supérieures.

Puis, une première étape d'irradiation ionique 400 est réalisée.

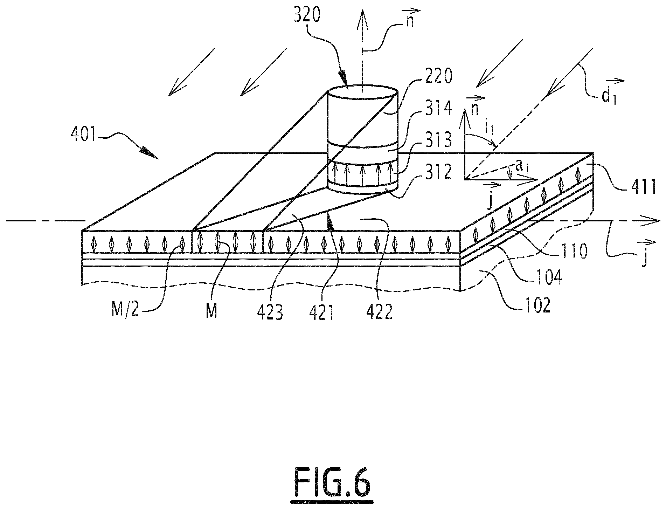

Le flux d'ions est dirigé selon une première direction d'incidence **d1** (figure 6). Un premier plan d'incidence est défini par la première direction d'incidence **d1** et la direction perpendiculaire **n.** Dans le plan de la piste conductrice, le premier plan d'incidence fait un premier angle a1 avec la direction **j.** Dans le premier plan d'incidence, le flux d'ions fait un premier angle d'incidence i1 avec la direction perpendiculaire **n.**

Au cours de cette étape, le pilier de masquage 320 projette une première ombre 421 sur la première couche magnétique étendue 411.

La hauteur H du pilier de masquage 320 et la première direction d'incidence **d1** sont choisies pour que cette première ombre 421 coïncide avec le contour de la première branche de la forme en « V » que l'on souhaite conférer au plot.

La partie de la première couche magnétique étendue 411, située à l'intérieur de cette première ombre 421, qui n'est donc pas exposée au flux d'ions, conserve ses propriétés magnétiques.

En revanche, la partie de la couche magnétique 411, située à l'extérieur de cette ombre projetée, et qui est donc exposée au flux d'ions, perd progressivement ses propriétés magnétiques. On choisit les paramètres de la première irradiation ionique de manière à ce que, à l'issue de l'étape 400, l'amplitude d'aimantation soit au moins diminuée de moitié.

Ceci est représenté sur la figure 6, où le composant 401 obtenu à l'issue de l'étape 400 comporte une première couche magnétique 411, qui, dans une zone 423, présente une amplitude maximum d'aimantation M, et, dans une zone 422, une amplitude d'aimantation M/2.

Puis, une seconde étape d'irradiation ionique 500 est réalisée.

Le flux d'ions est dirigé selon une seconde direction d'incidence **d2.** Un second plan d'incidence est défini par la seconde direction d'incidence **d2** et la direction perpendiculaire n. Dans le plan de la piste conductrice, le plan d'incidence fait un second angle a2 avec la direction **j.** Dans ce second plan d'incidence, le flux d'ions fait un second angle d'incidence i2 avec la direction perpendiculaire **n.**

Au cours de cette étape, le pilier de masquage 320 projette une seconde ombre 521 sur la première couche magnétique étendue.

Par exemple, pour que, lors de l'irradiation, la seconde ombre projetée par le pilier de masquage 320 délimite le contour de la seconde branche de la forme en « V » que l'on souhaite conférer au plot, le second angle a2 est égal à 180°- a1, et le second angle d'incidence i2 est égal à i1.

La partie de la première couche magnétique étendue 411 située à l'intérieure de cette seconde ombre, qui n'est donc pas exposée au flux d'ions, conserve les propriétés magnétiques qui étaient les siennes à l'issue de la première irradiation (étape 400).

En revanche, la partie de la couche magnétique étendue 411 située à l'extérieur de cette seconde ombre, qui est donc exposée au flux d'ions, perd progressivement ses propriétés magnétiques.

On choisit par exemple les paramètres de la seconde irradiation ionique pour qu'ils soient égaux à ceux de la première irradiation, pour diviser par deux une amplitude d'aimantation M.

Le composant 501 obtenu à l'issue de l'étape 500 présente alors une première couche magnétique 511 comportant :
Une zone 531 à l'intersection des première et seconde ombres 421 et 521 (et qui s'étend sous le pilier de masquage 320), qui présente une amplitude d'aimantation M, le matériau magnétique n'ayant pas été exposé.
Une zone 532 complémentaire de la zone 531 à l'intérieur de la première ombre 421, qui présente une amplitude d'aimantation M/2, le matériau magnétique ayant été exposé durant la seconde irradiation ionique 500 ;
Une zone 533 complémentaire de la zone 531 à l'intérieur de la seconde ombre 521, qui présente une amplitude d'aimantation M/2, le matériau magnétique ayant été exposé durant la première irradiation ionique 400 ; et,
Une zone 534 à l'extérieur de la première ombre 421 et à l'extérieur de la seconde ombre 521, qui présente une amplitude d'aimantation nulle, le matériau magnétique ayant été exposé à la fois durant la première irradiation ionique 400 et la seconde irradiation ionique 500.

Ainsi, la forme de la première région magnétique du plot a été « modelée » dans la première couche magnétique étendue 511.

Au cours d'une étape finale 600 de finition, le pilier de masquage primaire 220 est supprimé pour exposer la région d'électrode 14 et former la borne C. Cette opération est nécessaire lorsque le pilier de masquage primaire est en résine. En revanche, le pilier de masquage primaire peut être conservé lorsqu'il est réalisé dans un matériau conducteur du courant électrique et qu'il peut par conséquent permettre la circulation du courant de lecture.

La première couche magnétique étendue 511 est gravée de manière à exposer la piste conductrice 4. Cette étape de gravure si elle est précise en profondeur, n'a pas besoin de l'être latéralement, la région magnétiquement active du plot ayant été délimitée précisément par irradiation. Des électrodes 20 et 21 sont disposées à l'extrémité de la piste conductrice 4 pour former les bornes A et B.

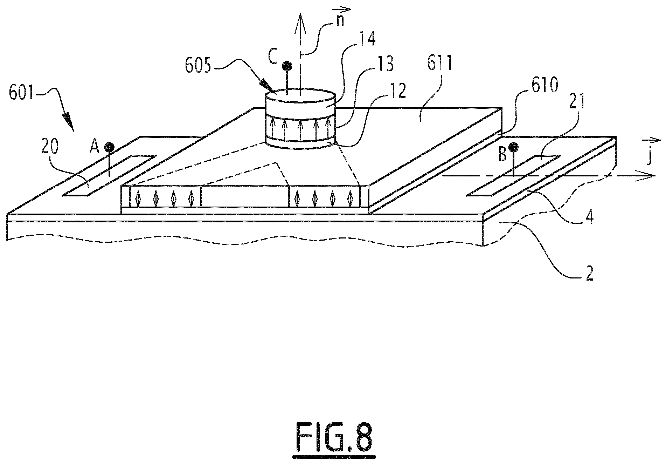

Ainsi, comme représenté sur la figure 8, la forme du point mémoire 601 obtenu par la mise en oeuvre du procédé 50 ne correspond pas exactement à celle du point mémoire 5. Si le plot 605 comporte bien une piste conductrice 4 sur un substrat 2 et des couches supérieures 12, 13 et 14 comme le plot 5, il présente une couche conductrice de contact 610 et une première couche magnétique 611 pouvant avoir une forme différente, plus étendue, par exemple rectangulaire, que celle des couches 10 et 11 du plot 5. Dans cette première couche magnétique 611, la région magnétiquement active, c'est-à-dire la première région magnétique du plot 605, est délimitée précisément avec l'asymétrie géométrique recherchée. Le point mémoire 601 est bien du type SOT-MRAM asymétrique et, dans le cas présent, à aimantation perpendiculaire.

Que les première et seconde régions magnétiques du plot n'aient pas la même géométrie ne présente pas de difficulté, puisque, lors de la lecture, c'est l'orientation relative de l'aimantation de part et d'autre de la jonction tunnel réalisée par la région intermédiaire 12 qui est déterminée par la mesure de la résistance électrique du plot 605.

En variante, on notera que la forme des couches supérieures correspond à l'empreinte du pilier de masquage primaire. Si celui-ci présente une autre géométrie que cylindrique, la géométrie des couches supérieures le reflètera.

Enfin, compte tenu de la longueur de pénétration R des ions, une partie du matériau de la première couche magnétique, qui est située sous la face latérale du plot exposée aux ions, est irradiée, modifiant le magnétisme à cet endroit. Plus l'angle d'incidence est rasant, plus cette partie présente une extension importante. C'est donc un compromis à trouver sur les paramètres d'irradiation compte tenu de l'extension de l'ombre projetée recherchée pour définir la première région magnétique. Une solution consiste notamment à diminuer l'énergie du faisceau d'ions pour diminuer la longueur de pénétration R.

L'homme du métier constatera par conséquent que la forme extérieure du point mémoire résultant de la mise en oeuvre du procédé selon l'invention diffère de celle du plot mémoire théorique, notamment dans les couches inférieures du plot, qui comportent au moins la première région magnétique (d'aimantation libre) asymétrique, alors que la forme extérieure de ces couches inférieures est quelconque (par exemple symétrique). Le point mémoire reflète par conséquent la manière dont il a été réalisé, c'est-à-dire les différentes étapes du procédé selon l'invention. Dit autrement, le point mémoire obtenu par la mise en œuvre du présent procédé est spécifique de ce procédé.

### 4. Production industrielle

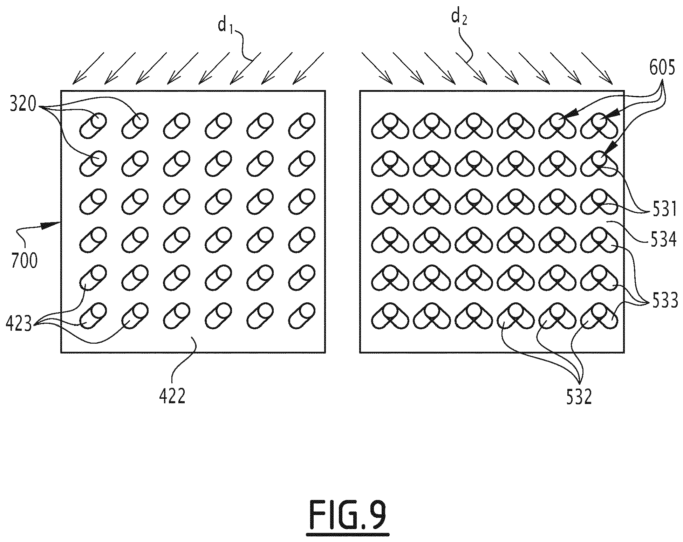

Comme représenté schématiquement sur la figure 9, le procédé présenté ci-dessus permet de produire simultanément un grand nombre de points mémoire sur une tranche de substrat 700.

Comme l'illustre la figure 9, après croissance des différentes couches étendues, des piliers de masquage primaires sont déposés selon un motif matriciel.

La première irradiation (partie de gauche de la figure 9), selon une première direction **d1**, permet de modeler une première branche de la forme en « V » que l'on souhaite conférer à tous les plots.

La seconde irradiation (partie de droite de la figure 9), selon une seconde direction **d2,** permet de modeler la seconde branche de la forme en « V » que l'on souhaite conférer à tous les plots.

A l'issue de la mise en oeuvre des étapes du procédé, on obtient une tranche de substrat 700 portant un ensemble de plots 605, qui sont disposés selon le motif initial des piliers de masquage primaire.

Ainsi, en une seule itération des étapes de la figure 2, un grand nombre de points mémoire sont fabriqués simultanément.

L'homme du métier comprendra par conséquent, que le présent procédé permet de répondre à l'industrialisation de la fabrication de points mémoire SOT-MRAM asymétriques.

### 5. Paramètres de l'irradiation ionique

De préférence, l'irradiation ionique est une irradiation d'ions légers, de préférence He+.

Ces ions présentent une énergie faible, entre 10 et 100 keV, par exemple de 30 keV.

L'intensité du flux ionique est caractérisée par sa fluence. Celle-ci est entre 10¹⁴ et 10¹⁷ ions/cm², de préférence 10¹⁶ ions/cm².

Avec de telles propriétés, le faisceau d'ions n'induit alors que des déplacements atomiques de quelques Angströms autour de la position d'équilibre des atomes, sans aucune collision en cascade et sans gravure physique ou implantation d'atomes. Cela permet de moduler l'aimantation globale du matériau magnétique jusqu'à la supprimer. Un faisceau de faible énergie permet donc de modifier la structure du matériau de façon contrôlée grâce au mélange des atomes du matériau, qui est induit par l'irradiation.

Avantageusement, pour une application industrielle, le faisceau d'ion présente une section étendue pour pouvoir irradier une surface importante, telle que celle d'une tranche de semi-conducteur, avec un angle d'incidence sensiblement constant sur toute la section.

La partie non irradiée par effet d'ombrage à la base du pilier de masquage a une extension latérale d.

Dans une première approximation : d = H x tan(i) ; où H est la hauteur du pilier de masquage et i l'angle d'incidence des ions (0° pour un faisceau vertical et 90° pour un faisceau horizontal).

Si on prend un pilier de masquage de hauteur H = 50 nm, d = 0 pour i = 0°, d = 50 nm pour i = 45°, et d = 280 nm pour i = 80°.

Ainsi, en fonction des paramètres du faisceau d'ions, ceux du pilier de masquage, et ceux de la forme du plot à réaliser, l'angle d'incidence est compris sur la gamme entre 0 et 90°.

La longueur de pénétration R des ions dans un matériau donné est un paramètre important qui dépend de l'énergie des ions et de l'intensité du faisceau. La longueur de pénétration R est donc à définir en fonction de l'épaisseur du matériau à irradier pour atteindre la première couche magnétique. Les intensités et énergies indiquées ci-dessus permettent d'envisager une large gamme de longueur de pénétration R et par conséquent d'épaisseurs à traverser.

En tenant compte de la longueur de pénétration, la partie totalement non irradiée par effet d'ombrage a une extension latérale d : d = tan(i) x [H - R x cos(i)], où H est la hauteur du pilier de masquage, i l'angle des ions et R la longueur de pénétration des ions.

Par exemple, pour une énergie de 20 keV, la longueur de pénétration R est typiquement de 60 nm. Avec un pilier de masquage de hauteur H = 50nm, d = 0 pour θ = 0°, d = 8nm pour i =45°, et d = 200 nm pour i = 80°.

### 6. Variantes de réalisation du procédé de fabrication

Le procédé présenté ci-dessus peut être modifié de différentes manières.

Après gravure du pilier de masquage, il peut être préférable de retirer la résine du pilier de masquage primaire, pour n'utiliser que les couches métalliques supérieures du plot en tant que masque pour la ou les étapes d'irradiation.

Il n'est pas nécessaire de mettre en oeuvre l'étape de gravure permettant d'exposer la première couche magnétique. Cela dépend de la longueur de pénétration R compte tenu notamment des caractéristiques des couches situées au-dessus de la première couche magnétique. S'il est possible de modifier par irradiation l'aimantation de la première couche magnétique sans avoir à éliminer tout ou partie des couches situées au-dessus de celle-ci, il est préférable de ne pas le faire, ne serait-ce que pour faciliter la mise en oeuvre du procédé en l'accélérant.

Par ailleurs, l'ordre des étapes peut être modifié. Ainsi, il est envisageable de créer un empilement partiel, limité aux couches inférieures et dont la couche étendue exposée soit la première couche magnétique. Le plot de masquage primaire est alors déposé directement sur la première couche magnétique et l'irradiation ionique permet d'y délimiter une région ayant la géométrie recherchée. Puis, après élimination du plot de masquage primaire, les régions supérieures constitutives du plot sont déposées : région intermédiaire, seconde région magnétique et région d'électrode.

Par ailleurs encore, le procédé peut être modifié lorsque l'on cherche à fabriquer des plots constitués par un autre empilement de régions que celui du plot de la figure 1. Par exemple, la région conductrice de contact peut en fait être une surépaisseur de la piste conductrice. Dans ce cas, l'étape finale consiste à poursuivre la gravure pour entamer la couche de conduction étendue.

Par exemple encore, la seconde couche magnétique n'est pas forcément nécessaire, bien que préférable. L'omettre permet de simplifier la réalisation de l'empilement et limiter l'intérêt de l'étape de gravure, la première couche magnétique étant alors plus accessible au faisceau d'ions.

Le procédé peut également être modifié lorsque l'on cherche à fabriquer des plots présentant une autre géométrie. Au lieu de fabriquer un plot en « V », si l'on souhaite fabriquer un plot par exemple triangulaire, les deux étapes d'irradiation peuvent être remplacées par une unique étape au cours de laquelle la source ionique est déplacée selon un mouvement continu par rapport au pilier de masquage de manière à ce que la course de l'ombre projetée délimite, dans la première couche magnétique, une zone triangulaire correspondant à la première région magnétique du plot. Les paramètres de l'irradiation sont ajustés pour qu'à l'extérieur de la zone ombrée le matériau magnétique perde son aimantation et à l'intérieur de la zone ombrée, le matériau magnétique conserve tout ou partie de son aimantation.

Par exemple encore, certaines géométries peuvent nécessiter de réaliser un plot de masquage ayant une autre géométrie et/ou une étape de modification de la géométrie du masque entre les première et seconde irradiations. On souhaite par exemple réaliser un plot comportant une portion centrale rectiligne selon la direction **j** et, à chacune de ses extrémités, une portion de pointe, disposée à angle par rapport à la portion centrale. Les portions de pointe sont situées du même côté de ce plan de référence défini par les directions **j** et **n.** Alors, dans une première étape de masquage, le plot de masquage est réalisé de manière à comporter une barre parallélépipédique portant à l'une de ses extrémités un premier cylindre. La première irradiation permet ainsi de délimiter, dans le matériau magnétique, une partie de la portion centrale et une première portion de pointe du plot à réaliser. Puis, dans une seconde étape de masquage, le plot de masquage est modifié en supprimant le premier cylindre du plot de masquage et un second cylindre est déposé à l'autre extrémité de la barre parallélépipédique. La seconde irradiation permet alors de délimiter dans le matériau magnétique une partie de la portion centrale et la seconde portion de pointe du plot à réaliser. Avantageusement, la seconde irradiation s'effectue après avoir tourné la source autour de la direction perpendiculaire **n** tout en restant du même côté du plot de masquage. L'angle pour la seconde irradiation est par exemple égal à 180° - a1, où a1 est l'angle de la première irradiation.

Par exemple encore, on peut utiliser un nombre différent d'étapes d'irradiation, notamment une seule étape d'irradiation. On souhaite par exemple définir une forme plus simple mais néanmoins non symétrique par rapport au plan de référence défini par les directions **n** et **j.** On utilise alors une seule étape de masquage en utilisant un plot cylindrique et une irradiation sous une seule direction **d1** présentant un angle a1 différent de 0° et 90°. La partie délimitée dans le matériau magnétique aura alors la forme obtenue après la première étape d'irradiation 400 telle que décrite précédemment et représentée en vue de dessus sur la partie de gauche de la figure 9. Dans ce cas, les paramètres de l'irradiation seront ajustés de telle façon qu'une seule exposition annule l'aimantation des zones exposées. Le reste des étapes se fera alors à l'identique de la description précédente à l'exception de l'étape 500 qui sera omise.

Bien que le procédé ait été décrit pour le cas d'une aimantation perpendiculaire au plan des régions constitutives du plot, il s'applique tout aussi bien au cas d'une aimantation parallèle au plan des régions constitutives du plot.

### 7. Plot pour lequel l'asymétrie provient d'un gradient des propriétés magnétiques et cas limite du présent procédé de fabrication

Le présent procédé permet d'obtenir un plot asymétrique même avec une seule étape d'irradiation ionique, notamment selon un plan d'incidence orthogonal au plan de référence du point mémoire.

En effet, lors d'une irradiation ionique, l'ombre projetée n'est pas absolument précisément délimitée, de sorte qu'à la suite de l'irradiation, les propriétés magnétiques du matériau magnétique présentent un gradient au voisinage des bords de l'ombre projetée. Ceci est notamment vrai pour le bord de l'ombre projetée correspondant à l'arête supérieure du pilier formant masque.

Dans le cas où l'irradiation s'effectue selon un plan d'incidence orthogonal au plan de référence, ce gradient est alors orienté perpendiculairement aux directions **j** et **n.** Or, ce gradient d'aimantation brise la symétrie miroir par rapport au plan de référence défini par les directions **j** et **n.** Par conséquent, la présence de ce gradient de l'aimantation suffit à créer une asymétrie dans le plot fabriqué. C'est un peu comme si la première région magnétique était en fait constituée de la superposition de strates magnétiques élémentaires de même aimantation, elliptiques, emboitées les unes dans autres, et décentrées les unes par rapport aux autres perpendiculairement à la direction **j.** On peut alors dire que l'asymétrie du plot est également une asymétrie géométrique. En choisissant l'angle d'incidence dans l'intervalle ouvert ]0°, 180°[, une unique irradiation ionique permet d'obtenir un gradient ayant une composante perpendiculairement au plan de référence et par conséquent de réaliser un point-mémoire SOT-MRAM asymétrique.

## Revendications

1. Procédé de fabrication (50) d'un point mémoire SOT-MRAM asymétrique, ledit point mémoire (1) comportant une piste conductrice (4) et un plot (5), disposé sur la piste conductrice et comportant au moins une première région magnétique (11) à aimantation libre, le procédé étant **caractérisé en ce qu'**il comporte les étapes consistant à :
- réaliser (100) un empilement (101) d'une pluralité de couches étendues, comportant au moins une première couche magnétique étendue (111) ;
- déposer (200) un masque (220) sur une surface supérieure de l'empilement (101) ; et,
- délimiter (400, 500) la première région magnétique (11) dans la première couche magnétique étendue (111) par une irradiation ionique de la surface supérieure de l'empilement portant le masque, les paramètres de l'irradiation ionique étant adaptés pour modifier des propriétés magnétiques du matériau constitutif de la première couche magnétiques (111),
le procédé étant **caractérisé en ce que** l'étape de délimitation par irradiation ionique comporte, au cours d'une durée de l'irradiation, un déplacement relatif d'une source d'ions par rapport à la surface supérieure de l'empilement portant le masque de manière à modifier une direction de l'irradiation, les paramètres de l'irradiation étant adaptés pour supprimer les propriétés magnétiques d'une zone exposée durant toute la durée de l'irradiation, mais pour ne pas supprimer les propriétés magnétiques d'une zone exposée uniquement pendant une fraction de la durée de l'irradiation.

2. Procédé de fabrication (50) d'un point mémoire SOT-MRAM asymétrique, ledit point mémoire (1) comportant une piste conductrice (4) et un plot (5), disposé sur la piste conductrice et comportant au moins une première région magnétique (11) à aimantation libre, le procédé étant **caractérisé en ce qu'**il comporte les étapes consistant à :
- réaliser (100) un empilement (101) d'une pluralité de couches étendues, comportant au moins une première couche magnétique étendue (111) ;
- déposer (200) un masque (220) sur une surface supérieure de l'empilement (101) ; et,
- délimiter (400, 500) la première région magnétique (11) dans la première couche magnétique étendue (111) par une irradiation ionique de la surface supérieure de l'empilement portant le masque, les paramètres de l'irradiation ionique étant adaptés pour modifier des propriétés magnétiques du matériau constitutif de la première couche magnétiques (111),
le procédé étant **caractérisé en ce que** l'étape de délimitation par irradiation ionique comporte une première irradiation (400) selon une première direction de l'irradiation (d1), suivie d'une seconde irradiation (500) selon une seconde direction de l'irradiation (d2), les paramètres de la première irradiation et de la seconde irradiation étant choisis pour supprimer les propriétés magnétiques d'une zone exposée à la fois lors de la première irradiation et lors de la seconde irradiation, mais pour ne pas supprimer les propriétés magnétiques d'une zone exposée uniquement lors de la première irradiation ou uniquement lors de la seconde irradiation.

3. Procédé selon la revendication 1 ou 2, dans lequel l'irradiation ionique permet de modifier les propriétés magnétiques d'une zone de la première couche magnétique (111) exposée lors de l'irradiation ionique, tout en conservant les propriétés magnétiques d'une zone de la première couche magnétique (111) non-exposée lors de l'irradiation ionique à cause de la présence du masque.

4. Procédé selon la revendication 2, comportant, entre la première irradiation ionique et la seconde irradiation ionique, une étape de modification du masque.

5. Procédé selon l'une quelconque des revendications précédentes, dans lequel l'irradiation ionique met en oeuvre des ions légers, de préférence He+, de faible énergie, de préférence entre 10 et 100 keV, de préférence encore égale à 30 keV, et avec une intensité entre 10¹⁴ et 10¹⁷ ions/cm², de préférence égale à 10¹⁶ ions/cm².

6. Procédé selon l'une quelconque des revendications précédentes, comportant, après l'étape de dépôt d'un masque (220) et avant l'étape de délimitation par irradiation ionique, une étape de gravure (300) consistant à graver les couches supérieures de l'empilement (101) autour du masque déposé (220) de manière à ce que le flux d'ions utilisé lors de l'irradiation ionique puisse atteindre la première couche magnétique (111).

7. Procédé selon l'une quelconque des revendications précédentes, dans lequel réaliser (100) un empilement (101) d'une pluralité de couches étendues consiste à superposer, sur un substrat semi-conducteur (102), une couche conductrice (104, 110), une première couche magnétique (111), une couche intermédiaire (112), une seconde couche magnétique (113) et une couche d'électrode (114).

8. Procédé selon l'une quelconque des revendications précédentes, comportant, après l'étape de délimitation par irradiation ionique, une étape de finition du point mémoire (600) consistant à supprimer le masque, à graver l'empilement pour exposer une piste conductrice de part et d'autre du plot, et réaliser des électrodes (A, B, C) à chacune des extrémités de la couche conductrice (4), ainsi que sur le plot (5).

9. Point mémoire SOT-MRAM asymétrique (601) obtenu par la mise en œuvre du procédé de fabrication (50) selon l'une quelconque des revendications précédentes.

## Patentansprüche

1. Verfahren zum Herstellen (50) eines asymmetrischen SOT-MRAM-Speicherpunkts, wobei der Speicherpunkt (1) eine Leiterbahn (4) und einen Kontakt (5) umfasst, der auf der Leiterbahn angeordnet ist und mindestens einen ersten magnetischen Bereich (11) mit freier Magnetisierung umfasst, wobei das Verfahren **dadurch gekennzeichnet ist, dass** es die Schritte umfasst, bestehend aus:
- Herstellen (100) eines Stapels (101) aus einer Vielzahl von ausgedehnten Schichten, umfassend mindestens eine erste ausgedehnte magnetische Schicht (111);
- Aufbringen (200) einer Blende (220) auf eine Oberseite des Stapels (101); und
- Abgrenzen (400, 500) des ersten magnetischen Bereichs (11) in der ersten ausgedehnten magnetischen Schicht (111) durch eine Ionenbestrahlung der Oberseite des Stapels, der die Blende trägt, wobei die Parameter der Ionenbestrahlung geeignet sind, um magnetische Eigenschaften des Materials, aus dem die erste magnetische Schicht (111) besteht, zu modifizieren,
wobei das Verfahren **dadurch gekennzeichnet ist, dass** der Schritt des Abgrenzens durch Ionenbestrahlung während einer Bestrahlungsdauer eine relative Verschiebung einer Ionenquelle in Bezug auf die Oberseite des Stapels, der die Blende trägt, umfasst, um eine Bestrahlungsrichtung zu modifizieren, wobei die Parameter der Bestrahlung geeignet sind, um die magnetischen Eigenschaften eines während der gesamten Bestrahlungsdauer ausgesetzten Bereichs aufzuheben, aber die magnetischen Eigenschaften eines nur während eines Bruchteils der Bestrahlungsdauer ausgesetzten Bereichs nicht aufzuheben.

2. Verfahren zum Herstellen (50) eines asymmetrischen SOT-MRAM-Speicherpunkts, wobei der Speicherpunkt (1) eine Leiterbahn (4) und einen Kontakt (5) umfasst, der auf der Leiterbahn angeordnet ist und mindestens einen ersten magnetischen Bereich (11) mit freier Magnetisierung umfasst, wobei das Verfahren **dadurch gekennzeichnet ist, dass** es die Schritte umfasst, bestehend aus:
- Herstellen (100) eines Stapels (101) aus einer Vielzahl von ausgedehnten Schichten, umfassend mindestens eine erste ausgedehnte magnetische Schicht (111);
- Aufbringen (200) einer Blende (220) auf eine Oberseite des Stapels (101); und
- Abgrenzen (400, 500) des ersten magnetischen Bereichs (11) in der ersten ausgedehnten magnetischen Schicht (111) durch eine Ionenbestrahlung der oberen Oberfläche des Stapels, der die Blende trägt, wobei die Parameter der Ionenbestrahlung geeignet sind, um magnetische Eigenschaften des Materials, aus dem die erste magnetische Schicht (111) besteht, zu modifizieren,
wobei das Verfahren **dadurch gekennzeichnet ist, dass** der Schritt des Abgrenzens durch Ionenbestrahlung eine erste Bestrahlung (400) entlang einer ersten Bestrahlungsrichtung (d1), gefolgt von einer zweiten Bestrahlung (500) entlang einer zweiten Bestrahlungsrichtung (d2) umfasst, wobei die Parameter der ersten Bestrahlung und der zweiten Bestrahlung ausgewählt sind, um die magnetischen Eigenschaften eines gleichzeitig während der ersten Bestrahlung und während der zweiten Bestrahlung ausgesetzten Bereichs aufzuheben, aber die magnetischen Eigenschaften eines nur während der ersten Bestrahlung oder nur während der zweiten Bestrahlung ausgesetzten Bereichs aufzuheben.

3. Verfahren nach Anspruch 1 oder 2, wobei die Ionenbestrahlung es ermöglicht, die magnetischen Eigenschaften eines Bereichs der ersten magnetischen Schicht (111) zu modifizieren, die während der Ionenbestrahlung ausgesetzt wird, während die magnetischen Eigenschaften eines Bereichs der ersten magnetischen Schicht (111), die aufgrund der Anwesenheit der Blende während der Ionenbestrahlung nicht ausgesetzt wird, erhalten bleiben.

4. Verfahren nach Anspruch 2, umfassend zwischen der ersten Ionenbestrahlung und der zweiten Ionenbestrahlung einen Schritt zum Modifizieren der Blende.

5. Verfahren nach einem der vorstehenden Ansprüche, wobei die Ionenbestrahlung leichte Ionen, vorzugsweise He+, mit niedriger Energie, vorzugsweise zwischen 10 und 100 keV, weiter bevorzugt gleich 30 keV, und mit einer Intensität zwischen 10¹⁴ und 10¹⁷ Ionen/cm², vorzugsweise gleich 10¹⁶ Ionen/cm², einsetzt.

6. Verfahren nach einem der vorstehenden Ansprüche, umfassend, nach dem Schritt des Aufbringens einer Blende (220) und vor dem Schritt des Abgrenzens durch Ionenbestrahlung, einen Ätzschritt (300), der aus dem Ätzen der oberen Schichten des Stapels (101) um die aufgebrachte Blende (220) herum besteht, sodass der Ionenstrom, der während der Ionenbestrahlung verwendet wird, die erste magnetische Schicht (111) erreichen kann.

7. Verfahren nach einem der vorstehenden Ansprüche, wobei das Erzeugen (100) eines Stapels (101) aus einer Vielzahl von ausgedehnten Schichten darin besteht, auf einem Halbleitersubstrat (102) eine leitfähige Schicht (104, 110), eine erste magnetische Schicht (111), eine Zwischenschicht (112), eine zweite magnetische Schicht (113) und eine Elektrodenschicht (114) übereinander zu legen.

8. Verfahren nach einem der vorstehenden Ansprüche, umfassend, nach dem Schritt des Abgrenzens durch Ionenbestrahlung, einen Schritt eines Fertigstellens des Speicherpunkts (600), der aus dem Aufheben der Blende, dem Ätzen des Stapels, um auf beiden Seiten des Kontakts eine Leiterbahn freizulegen, und dem Erzeugen von Elektroden (A, B, C) an jedem der Enden der leitfähigen Schicht (4) sowie an dem Kontakt (5) besteht.

9. Asymmetrischer SOT-MRAM-Speicherpunkt (601), der durch Einsetzen des Herstellungsverfahrens (50) nach einem der vorstehenden Ansprüche erhalten wird.

## Claims

1. A method for fabricating (50) an asymmetric SOT-MRAM memory point, said memory point (1) including a conductive track (4) and a pad (5) disposed on the conductive track and including at least one first magnetic region (11) with free magnetisation, the method being **characterised in that** it includes the steps consisting in:
- making (100) a stack (101) of a plurality of extended layers, including at least one first extended magnetic layer (111);
- depositing (200) a mask (220) onto an upper surface of the stack (101); and,
- delimiting (400, 500) the first magnetic region (11) in the first extended magnetic layer (111) by ion irradiation of the upper surface of the stack carrying the mask, the parameters of the ion irradiation being adapted to modify magnetic properties of the constituent material of the first magnetic layer (111),
the method being **characterized in that** the ion irradiation delimitation step includes, during an irradiation duration, a relative displacement of an ion source with respect to the upper surface of the stack carrying the mask in order to modify a direction of irradiation, the irradiation parameters being adapted to remove the magnetic properties of a zone exposed during the whole irradiation duration but not to remove the magnetic properties of a zone exposed only during a fraction of the irradiation duration.

2. A method for fabricating (50) an asymmetric SOT-MRAM memory point, said memory point (1) including a conductive track (4) and a pad (5) disposed on the conductive track and including at least one first magnetic region (11) with free magnetisation, the method being **characterised in that** it includes the steps consisting in:
- making (100) a stack (101) of a plurality of extended layers, including at least one first extended magnetic layer (111);
- depositing (200) a mask (220) onto an upper surface of the stack (101); and,
- delimiting (400, 500) the first magnetic region (11) in the first extended magnetic layer (111) by ion irradiation of the upper surface of the stack carrying the mask, the parameters of the ion irradiation being adapted to modify magnetic properties of the constituent material of the first magnetic layer (111),
the method being **characterized in that** the ion irradiation delimitation step includes a first irradiation (400) along a first direction of irradiation (d1), followed by a second irradiation (500) along a second direction of irradiation (d2), the parameters of the first irradiation and the second irradiation being chosen to remove the magnetic properties of a zone exposed during both the first irradiation and the second irradiation, but not to remove the magnetic properties of a zone exposed only during the first irradiation or only during the second irradiation.

3. The method according to claim 1 or 2, wherein the ion irradiation allows for modifying the magnetic properties of a zone of the first magnetic layer (111) exposed during the ion irradiation, while retaining the magnetic properties of a zone of the first magnetic layer (111) not exposed during the ion irradiation because of the presence of the mask.

4. The method according to claim 2, including, between the first ion irradiation and the second ion irradiation, a step of modifying the mask.

5. The method according to any of the preceding claims, wherein ion irradiation implements light ions, preferably He+, of low energy, preferably between 10 and 100 keV, still more preferably equal to 30 keV, and with an intensity between 10¹⁴ and 10¹⁷ ions/cm², preferably equal to 10¹⁶ ions/cm².

6. The method according to any of the preceding claims, including, after the step of depositing a mask (220) and before the ion irradiation delimitation step, an etching step (300) consisting in etching the upper layers of the stack (101) around the mask (220) deposited so that the ion flow used during ion irradiation can reach the first magnetic layer (111).

7. The method according to any of the preceding claims, wherein making (100) a stack (101) of a plurality of extended layers consists in superimposing, on a semiconductor substrate (102), a conductive layer (104, 110), a first magnetic layer (111), an intermediate layer (112), a second magnetic layer (113) and an electrode layer (114).

8. The method according to any of the preceding claims, including, after the ion irradiation delimitation step, a step of finishing the memory point (600) consisting in removing the mask, etching the stack to expose a conductive track on either side of the pad, and making electrodes (A, B, C) at each of the ends of the conductive layer (4), as well as on the pad (5).

9. An asymmetric SOT-MRAM memory point (601) obtained by implementing the fabrication method (50) according to any of the preceding claims.
